(19) Europäisches Patentamt
European Patent Office
Office européen des brevets

(11) **EP 0 567 380 B1**

(12) **FASCICULE DE BREVET EUROPEEN**

(45) Date de publication et mention de la délivrance du brevet:
**20.11.1996 Bulletin 1996/47**

(51) Int Cl.⁶: **H03F 1/32**, H03F 3/58

(21) Numéro de dépôt: **93400999.4**

(22) Date de dépôt: **16.04.1993**

(54) **Procédé et dispositif de compensation des instabilités de phase de l'onde amplifiée par un tube hyperfréquence**

Verfahren und Vorrichtung zur Kompensation von Phasenschwankungen von einer mit einem Hochfrequenzrohr verstärkten Welle

Method and device for compensation of phase instabilities of a wave amplified by a microwave tube

(84) Etats contractants désignés:
**CH DE FR GB IT LI SE**

(30) Priorité: **24.04.1992 FR 9205060**

(43) Date de publication de la demande:
**27.10.1993 Bulletin 1993/43**

(73) Titulaire: **THOMSON-CSF**
**75008 Paris (FR)**

(72) Inventeur: **Cote, Gilles**
**F-92402 Courbevoie Cedex (FR)**

(74) Mandataire: **Benoit, Monique et al**
**THOMSON-CSF**
**SCPI**
**B.P. 329**
**50, rue Jean-Pierre Timbaud**
**92402 Courbevoie Cédex (FR)**

(56) Documents cités:
**EP-A- 0 441 579**    **WO-A-91/06149**
**US-A- 3 426 291**    **US-A- 4 905 086**

## Description

La présente invention concerne un procédé et dispositif de compensation d'une variation de tension entre les électrodes du tube d'un amplificateur hyperfréquence tendant à diminuer la variation de phase de l'onde amplifiée pour assurer sa stabilité.

Elle s'applique notamment à l'amélioration de la stabilité de phase des émetteurs de radar à tube hyperfréquence lorsque ceux-ci sont soumis par exemple à des variations importantes du rapport cyclique de la forme d'onde émise. Plus généralement, elle s'applique à tous types d'amplificateurs à tube hyperfréquence soumis à de grandes variations de charge.

Parmi les divers types d'instabilité affectant le fonctionnement des émetteurs à tube hyperfréquence, l'instabilité de phase est prépondérante. Cette dernière altère la qualité de l'onde émise et empêche notamment des traitements Doppler connus de l'homme de métier utilisant des mesures de variations de phases entre l'onde émise et l'onde reçue par un radar. Ces instabilités de phases sont dues à des variations de tension entre la cathode et le corps du tube. Dans le cas d'un klystron ou d'un tube à onde progressive par exemple, une variation de 1 % de cette tension entraîne respectivement des rotations de phase d'environ 20° et 40°. Les variations de la tension entre la cathode et le corps du tube de l'émetteur, sont dues à des variations, plus ou moins brusques, de charge aux bornes de l'alimentation électrique fournissant cette tension. Ces variations de charge ont lieu par exemple lors d'un passage de l'état silence du radar à une émission pleine puissance, ou plus généralement lors de variations importantes du rapport cyclique de la forme d'onde émise, représentant des enchaînements de motifs ou rafales à valeurs moyennes très différentes.

Une première solution connue diminuant ces rotations de phase consiste à réguler très précisément la tension entre la cathode et le corps du tube de l'émetteur pour limiter ses variations, à 1 % environ de sa valeur nominale par exemple. Pour cela, cette solution nécessite notamment d'avoir recours à des alimentations à haute fréquence de découpage équipées de systèmes de régulation très performants à large bande passante et à gain élevé. Cependant, la valeur nominale de la tension est généralement fixée dans une fourchette allant de quelques kilo-volts à plusieurs dizaines de kilovolts, ce qui complique encore la réalisation de ces alimentations et surtout les rend très couteuses, en particulier parce qu'elles nécessitent des circuits et des composants de grande précision et tenue en tension, ainsi que de très grandes précautions de mise au point.

Cette première solution étant écartée pour des raisons économiques, une autre solution connue asservit en phase le signal amplifié par l'émetteur sur le signal qu'il reçoit, ce qui permet l'utilisation d'alimentations moins performantes donc moins coûteuses. Néanmoins, dans ce cas il est impossible d'obtenir de la boucle d'asservissement de phase, un fonctionnement stable pour des rotations de phase supérieures à 90° car le gain de boucle devient alors négatif à cause des caractéristiques de la fonction de transfert sinusoïdale des mélangeurs utilisés dans la boucle. Une telle rotation de phase peut être atteinte par exemple par un tube à onde progressive dont la tension entre ses électrodes varie de 2 % environ.

Cette dernière solution peut toutefois être améliorée en ajoutant à la boucle d'asservissement de phase un échantillonneur bloqueur, pour prépositionner la correction à apporter à l'impulsion à traiter avec la correction retenue pour l'impulsion précédente. L'échantillonneur bloqueur mémorise en fait le signal d'erreur sur l'impulsion qui vient d'être corrigée et prépositionne le déphaseur de la boucle d'asservissement pour la prochaine correction. Cette amélioration reste insuffisante car elle ne prend pas en compte notamment les fluctuations entre les impulsions puisque par principe elle n'est efficace que pour des impulsions se reproduisant de façon sensiblement identique.

Par ailleurs, un tel échantillonneur bloqueur est d'usage délicat et complique les mises au point.

Le but de l'invention est de pallier les inconvénients précités, notamment en compensant l'effet d'une variation de tension entre les électrodes du tube d'un amplificateur hyperfréquence sur la phase de l'onde amplifiée, en injectant cette variation dans la boucle d'asservissement de cette phase.

A cet effet, l'invention a pour objet un procédé de compensation d'une variation de tension entre les électrodes du tube d'un amplificateur hyperfréquence, la variation de tension provoquant un déphasage de l'onde de sortie de l'amplificateur hyperfréquence, caractérisé en ce qu'il consiste à créer un déphasage de l'onde entrant dans le tube de l'amplificateur hyperfréquence sensiblement proportionnel à la variation de tension et de sens opposé au déphasage de l'onde de sortie créé par cette variation de tension.

L'invention a également pour objet un dispositif pour la mise en oeuvre du procédé précité.

Outre le fait qu'elle supprime les instabilités de phase, l'invention a pour principaux avantages qu'elle est économique, simple à mettre en oeuvre et qu'elle s'adapte à tous les types d'amplificateurs ou d'émetteurs à tube hyperfréquence.

D'autres caractéristiques et avantages de l'invention apparaîtront à l'aide de la description qui suit faite en regard des dessins annexés qui représentent :

- la figure 1, un asservissement de la phase du signal de sortie d'un amplificateur à tube hyperfréquence selon l'art antérieur ;
- la figure 2a, une illustration d'une variation de tension entre les électrodes du tube d'un amplificateur hyperfréquence selon l'art antérieur ;
- la figure 2b, une illustration de la fonction de transfert d'un mélangeur utilisé dans l'asservissement précité ;

- la figure 3, un mode de réalisation possible d'un dispositif pour la mise en oeuvre du procédé selon l'invention.

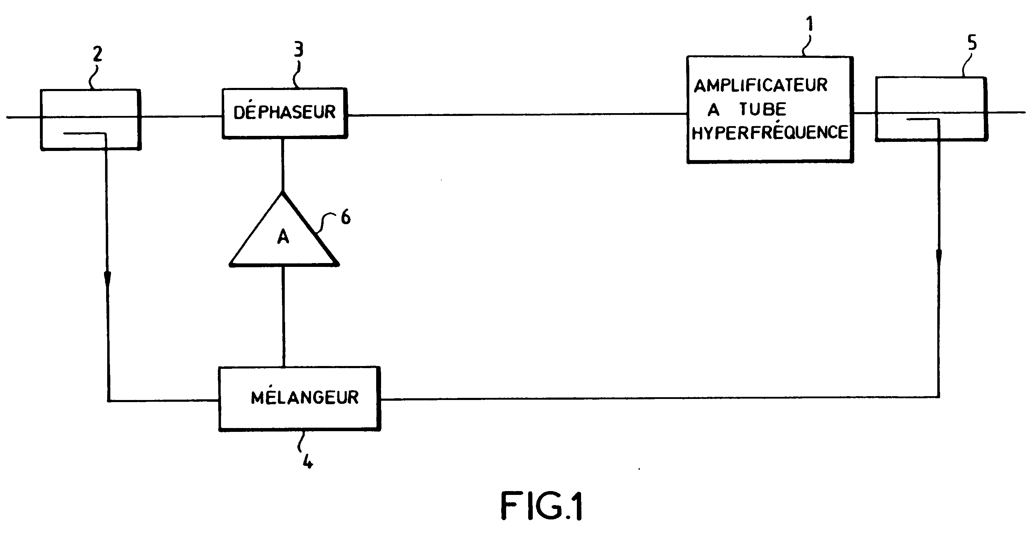

La figure 1 présente le synoptique d'un asservissement de la phase du signal de sortie d'un amplificateur à tube hyperfréquence 1 sur la phase d'une onde de référence, cette onde étant généralement l'onde à amplifier, c'est-à-dire l'onde reçue par l'amplificateur 1. Cet asservissement, connu dans l'art antérieur, permet de limiter en partie les variations de phase de l'onde de sortie amplifiée par l'amplificateur à tube hyperfréquence 1, ces variations étant dues notamment à des ondulations résiduelles de la tension d'alimentation du tube, à des bruits de phase intrinsèques au tube ou à des variations de charge de l'alimentation du tube. Les deux premières causes de variation de la phase, étant relativement limitées et reproductibles au cours du temps, sont efficacement compensées par le type d'asservissement illustré par le synoptique de la figure 1.

A cet effet, la boucle d'asservissement comporte par exemple un coupleur d'entrée 2 qui reçoit l'onde à amplifier, un déphaseur relié à la sortie principale du coupleur d'entrée 2, un mélangeur 4 qui reçoit du coupleur d'entrée 2 une image de l'onde reçue par ce dernier, un coupleur de sortie 5 dont l'entrée est reliée à la sortie de l'amplificateur à tube hyperfréquence 1 et fournissant au mélangeur 4 une image de l'onde de sortie de l'amplificateur à tube 1, et un amplificateur analogique 6 dont l'entrée est reliée à la sortie du mélangeur 4 et dont la sortie est reliée à l'entrée de commande du déphaseur 3, la sortie de ce dernier étant reliée à l'entrée de l'amplificateur à tube hyperfréquence 1. La sortie du mélangeur 4 fournit à l'amplificateur analogique 6 une tension représentative de la différence de phase entre les deux ondes qu'il reçoit, c'est-à-dire entre l'onde d'entrée du coupleur 2, jouant ici le rôle d'onde de référence, et l'onde de sortie de l'amplificateur à tube 1. La tension d'entrée de l'amplificateur analogique 6 est par exemple amplifiée par ce dernier pour commander le déphasage de l'onde entrant dans l'amplificateur à tube 1 par le déphaseur 3. Ce dernier crée généralement un déphasage fonction de sa tension de commande. L'action de l'amplificateur analogique 6 est par exemple corrigée par des combinaisons de circuits intégrateurs ou dérivateurs destinés à assurer la stabilité de l'asservissement et non représentés sur le synoptique de la figure 1 car connus du l'homme de métier.

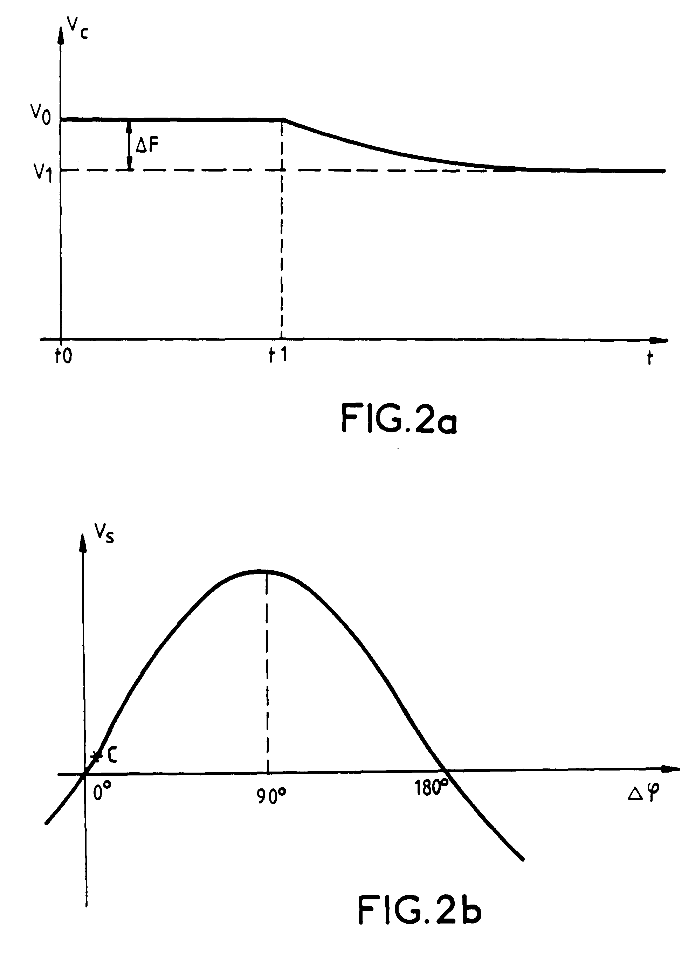

Dans le cas d'une variation trop importante de tension entre les électrodes du tube de l'amplificateur 1, entre sa cathode et son corps notamment, la boucle d'asservissement présentée par la figure 1 ne permet plus d'obtenir un fonctionnement stable. La figure 2a illustre une telle variation de tension. Cette figure représente la tension $Vc$ entre la cathode et le corps du tube de l'amplificateur 1 en fonction du temps. Si l'amplificateur à tube hyperfréquence est contenu par exemple dans un émetteur de radar, une tension $Vo$ initiale délivrée entre un instant d'origine $to$ et un temps $t1$ peut correspondre par exemple à une phase de silence radar.

A partir du temps $t1$, une émission de pleine puissance peut par exemple être déclenchée. Cela crée une variation de charge aux bornes de l'alimentation fournissant la tension $Vc$ entre la cathode et le corps du tube et provoque une chute de cette tension qui atteint au bout d'un certain temps une nouvelle tension d'équilibre $V1$.

A moins que la régulation de l'alimentation soit très performante, la variation $\Delta V$ de tension entre la cathode et le corps du tube crée une variation de phase, encore appelée rotation de phase, supérieure à 90°, de l'onde de sortie de l'amplificateur à tube hyperfréquence. En effet, pour un amplificateur à tube à onde progressive par exemple, une variation de tension d'environ 2 % crée une rotation de phase d'environ 90° de son onde de sortie. Pour des alimentations standards, une variation importante du rapport cyclique de la forme d'onde amplifiée provoque une telle variation, voire supérieure, et induit ainsi une rotation de phase supérieure à 90 °.

Dans le cas d'un émetteur de radar à tube hyperfréquence, ces variations peuvent résulter du passage d'un mode à un autre, en particulier du mode silence à un mode d'émission et plus généralement de toute variation du rapport cyclique de la forme d'onde émise représentant des enchaînements de motifs ou rafales à valeurs moyennes très différentes.

C'est en fait la rotation de phase supérieure à 90° qui empêche à l'asservissement présenté par la figure 1 d'atteindre un fonctionnement stable. En effet, dans ce cas, le gain de sa boucle qui dépend de la fonction de transfert du mélangeur 4 est négatif. La figure 2b illustre cette fonction de transfert, elle représente la tension de sortie $Vs$ du mélangeur 4 en fonction du déphasage $\Delta \varphi$ entre ses deux ondes d'entrée , c'est-à-dire entre l'onde de sortie de l'amplificateur 1 et l'onde d'entrée de la boucle d'asservissement, dont la phase est par exemple prise ici comme référence. Le gain de la boucle d'asservissement est principalement fonction du gain de l'amplificateur analogique 6 et de la pente de la fonction de transfert du mélangeur au point de fonctionnement considéré. La fonction de transfert du mélangeur étant sinusoïdale, entre 0° et 90° sa pente est positive. En revanche au delà de 90°, sa pente devient négative. Le gain de l'amplificateur analogique 6 étant positif, il en résulte que le gain global de la boucle d'asservissement est négatif, ce qui empêche l'asservissement de tendre vers un fonctionnement stable. Les instabilités de phase ainsi produites, prépondérantes devant tous les autres types d'instabilité, provoquent un bruit de phase altérant gravement la qualité de l'onde émise.

Dans le cas d'émetteurs à tube hyperfréquence, ces instabilités perturbent notamment les traitements Doppler.

Pour compenser une variation de tension entre les électrodes du tube de l'amplificateur 1, notamment pour supprimer les instabilités de phase précédemment décrites, le procédé selon l'invention déphase l'onde entrant dans le tube dans le sens opposé au déphasage créé par une variation de tension, et ce déphasage est sensiblement proportionnel à cette variation de tension. En effet, les calculs et les expériences effectués par la déposante ont montré que le déphasage créé par la variation de tension entre les électrodes du tube, entre sa cathode et son corps notamment, est généralement, au premier ordre, proportionnel à cette variation de tension. De plus, pour chaque tube hyperfréquence, il est possible de connaître le coefficient de proportionnalité , noté $\lambda$ par la suite. $\lambda$ est un nombre réel positif.

Si $\Delta V$ désigne la variation de tension entre les électrodes du tube et $\Delta \varphi$ le déphasage de l'onde de sortie de celui-ci causé par cette variation $\Delta V$, alors, au premier ordre, la relation suivante est vérifiée :

$$\Delta \varphi = \lambda \, \Delta V \qquad (1)$$

Si $\Delta \varphi'$ désigne le déphasage créé sur l'onde entrant dans le tube par le procédé selon l'invention, $\Delta \varphi'$ étant proportionnel à $\Delta V$ et de sens opposé à $\Delta \varphi$, la relation suivante est également vérifiée :

$$\Delta \varphi' = - \lambda' \, \Delta V \qquad (2)$$

ou $\lambda'$ désigne un nombre réel positif
$\lambda$ étant connu d'après les caractéristiques du tube, il est possible de créer un déphasage $\Delta \varphi'$ sur l'onde d'entrée de l'amplificateur égal en valeur absolue et opposé au déphasage $\Delta \varphi$ affectant l'onde de sortie de l'amplificateur en prenant $\lambda' = \lambda$ . Dans ce cas, le rapport du déphasage de l'onde entrant dans le tube sur la variation de tension entre les électrodes de ce dernier est sensiblement égal, en valeurs absolues, au rapport de déphasage de l'onde de sortie de l'amplificateur 1 créé par la variation de tension sur cette même variation de tension. Néanmoins dans la pratique $\lambda'$ peut être pris très légèrement différent de $\lambda$, voire différent, à cause du fait notamment que les caractéristiques de déphasage peuvent être différentes d'un tube à l'autre, sans nuire au résultat apporté par le procédé selon l'invention qui est notamment de rendre stable le fonctionnement de la boucle d'asservissement de phase de l'onde de sortie de l'amplificateur à tube hyperfréquence 1. En effet, l'instabilité étant provoquée par la présence du point de fonctionnement du mélangeur 4 sur une partie de sa fonction de transfert où la pente est négative, un des buts principaux de l'invention est de ramener ce point de fonctionnement où la pente est positive, il n'est pas nécessaire pour cela que $\lambda = \lambda'$. Néanmoins, si c'est le cas, si en

effet $\lambda$ et $\lambda'$ sont égaux, ou du moins sensiblement égaux, le point de fonctionnement du mélangeur sur sa fonction de transfert est ramené très près du déphasage $\Delta \varphi$ nul, égal à 0°, comme l'illustre par exemple le point C sur la courbe de la figure 2b. Or, au voisinage du déphasage $\Delta \phi$ nul, proche de 0°, la pente de la courbe sinusoïdale représentative de la fonction de transfert du mélangeur est maximale, donc en ce voisinage le gain global de la boucle d'asservissement est maximal et en conséquence les performances de la boucle sont les meilleures.

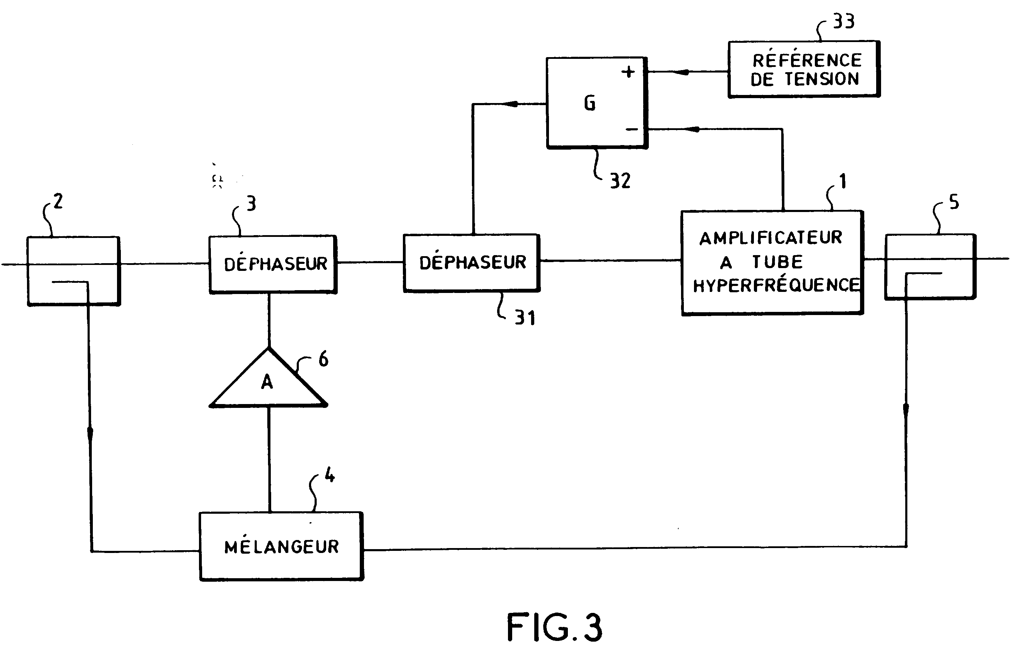

La figure 3 présente un mode de réalisation possible pour la mise en oeuvre du procédé selon l'invention. Ce dispositif est intégré dans la boucle d'asservissement présentée par la figure 1 ; il comporte au moins un deuxième déphaseur 31, des moyens d'amplification 32 et une référence de tension 33. Le deuxième déphaseur 31 est par exemple intercalé entre le premier déphaseur 3 et l'amplificateur à tube hyperfréquence 1, son entrée étant reliée à la sortie du premier déphaseur 3 et sa sortie à l'entrée de l'amplificateur 1. L'entrée de commande du deuxième déphaseur 31 est reliée à la sortie des moyens d'amplification 32. Cette sortie délivre une tension proportionnelle à la différence de tension présente entre l'entrée positive et l'entrée négative des moyens d'amplification 32. L'entrée positive des moyens d'amplification 32 est reliée à la sortie de la référence de tension 33. Cette référence de tension 33 fournit par exemple au moyen d'amplification 32 une tension correspondant à la tension nominale de fonctionnement du tube de l'amplificateur 1. L'entrée négative des moyens d'amplification 32 est reliée à une sortie de l'amplificateur à tube hyperfréquence 1 fournissant une image de la tension présente entre les électrodes du tube. Ainsi, si $\Delta V$ désigne la variation de tension entre ces électrodes par rapport à la tension nominale du tube et si G désigne le gain des moyens d'amplification 32, le deuxième déphaseur 31 étant linéaire, si k désigne son coefficient de transfert entre sa tension de commande et le déphasage qu'il crée, alors, le déphasage $\Delta \varphi'$ appliqué sur l'onde entrante dans le tube de l'amplificateur 1 est donné par la relation suivante :

$$\Delta \varphi' = k \, G \, \Delta V \qquad (3)$$

Le déphasage $\Delta \varphi$ créé par la variation de tension $\Delta V$ est donné par la relation (1) et k est une donnée intrinsèque au deuxième déphaseur 31. En conséquence d'après les relations (1) et (3) pour obtenir un déphasage $\Delta \varphi'$ égal au déphasage $\Delta \varphi$ il suffit de régler le gain G des moyens d'amplification 32 de façon à ce que :

$$\lambda = kG, \text{ soit } G = \frac{\lambda}{k}$$

Le procédé selon l'invention peut aussi être appliqué en boucle ouverte, c'est-à-dire sans asservissement de la phase de l'onde de sortie de l'amplificateur à tube hyperfréquence 1, c'est-à-dire que dans le cas d'application de la figure 3 par exemple, le premier coupleur 2, le mélangeur 4, l'amplificateur analogique 6, le premier déphaseur 3 et le deuxième coupleur 5 constituant la boucle d'asservissement pourraient être supprimés. Le dispositif restant, de mise en oeuvre du procédé selon l'invention, assure à lui seul un bon niveau de stabilité de la phase de l'onde de sortie de l'amplificateur 1.

En cas d'asservissement de cette phase, celui-ci peut être réalisé par exemple en technique numérique.

Les moyens d'amplification 32 du dispositif de mise en oeuvre du procédé selon l'invention peuvent être par exemple constitués d'un ou plusieurs amplificateurs opérationnels et d'un réseau de résistances câblés de façon connue de l'homme du métier. Ces moyens d'amplification peuvent notamment contenir un pont de lecture à base de résistances permettant d'obtenir un niveau de tension bas, représentatif de la haute tension présente entre les électrodes du tube de l'amplificateur 1.

## Revendications

1.  Procédé de compensation d'une variation de tension entre les électrodes du tube d'un amplificateur hyperfréquence (1), la variation de tension provoquant un déphasage de l'onde de sortie de l'amplificateur hyperfréquence (1), caractérisé en ce qu'il consiste à créer un déphasage de l'onde entrant dans le tube de l'amplificateur hyperfréquence (1) sensiblement proportionnel à la variation de tension et de sens opposé au déphasage de l'onde de sortie créé par cette variation de tension.

2.  Procédé selon la revendication 1, caractérisé en ce que le rapport du déphasage de l'onde entrant dans le tube sur la variation de tension est sensiblement égal au rapport du déphasage de l'onde de sortie créé par la variation de tension sur cette même variation de tension, en valeurs absolues.

3.  Procédé selon l'une quelconque des revendications 1 ou 2, caractérisé en ce que l'amplificateur hyperfréquence (1) est muni en outre d'une boucle d'asservissement (2, 3, 4, 5, 6) de la phase de son onde de sortie sur la phase d'une onde hyperfréquence de référence.

4.  Procédé selon la revendication 3, caractérisé en ce que l'onde de référence est l'onde à amplifier par l'amplificateur hyperfréquence (1).

5.  Procédé selon l'une quelconque des revendications précédentes, caractérisé en ce que l'amplificateur hyperfréquence (1) est contenu dans un émetteur hyperfréquence.

6.  Dispositif pour la mise en oeuvre du procédé selon l'une quelconque des revendications précédentes, caractérisé en ce qu'il comporte au moins :

    -   des moyens d'amplification (32) délivrant à leur sortie une tension proportionnelle à la différence de tension présente entre leur entrée positive et leur entrée négative, une entrée étant reliée à une sortie de l'amplificateur hyperfréquence (1) donnant une image de la tension entre les électrodes du tube
    -   une référence de tension (33) reliée à l'autre entrée des moyens d'amplifications (32)
    -   un déphaseur (31) dont l'entrée reçoit l'onde à amplifier, son entrée de commande étant reliée à la sortie des moyens d'amplification (32) et sa sortie étant reliée à l'entrée de l'amplificateur hyperfréquence (1).

7.  Dispositif selon la revendication 6, caractérisé en ce que la référence de tension (33) délivre une image de la tension nominale entre les électrodes du tube de l'amplificateur hyperfréquence (1).

8.  Dispositif selon l'une quelconque des revendications 6 ou 7, caractérisé en ce qu'il est associé à une boucle d'asservissement de la phase de l'onde de sortie de l'amplificateur hyperfréquence comportant :

    -   un premier coupleur (2) recevant le signal à amplifier dont une sortie est reliée à l'entrée d'un mélangeur (4)
    -   un deuxième coupleur (5) dont l'entrée est reliée à la sortie de l'amplificateur hyperfréquence (1) et une sortie est reliée à l'autre entrée du mélangeur (4)
    -   un amplificateur analogique (6) dont l'entrée est reliée à la sortie du mélangeur (4)
    -   un deuxième déphaseur (3) dont l'entrée est reliée à la sortie du premier coupleur (2), son entrée de commande étant reliée à la sortie de l'amplificateur analogique (6) et sa sortie étant reliée à l'entrée du déphaseur (31).

## Patentansprüche

1.  Verfahren zum Kompensieren einer Spannungsänderung zwischen den Elektroden einer Röhre eines Höchstfrequenzverstärkers (1), wobei die Spannungsänderung eine Phasenverschiebung der Ausgangswelle des Höchstfrequenzverstärkers (1) hervorruft, dadurch gekennzeichnet, daß es darin besteht, eine Phasenverschiebung der Eingangswelle der Röhre des Höchstfrequenzverstärkers (1) zu erzeugen, die im wesentlichen der Spannungsänderung proportional und der durch diese Spannungsänderung hervorgerufenen Phasenverschiebung der Ausgangswelle entgegengesetzt ist.

2. Verfahren nach Anspruch 1, dadurch gekennzeichnet, daß das Verhältnis der Phasenverschiebung der Eingangswelle der Röhre zur Spannungsänderung den Absolutwerten nach im wesentlichen gleich dem Verhältnis der durch diese Spannungsänderung hervorgerufenen Phasenverschiebung der Ausgangswelle zu dieser Spannungsänderung ist.

3. Verfahren nach einem der Ansprüche 1 oder 2, dadurch gekennzeichnet, daß der Höchstfrequenzverstärker (1) mit einer Regelschleife (2, 3, 4, 5, 6) der Phase seiner Ausgangswelle zur Phase einer Referenz-Höchstfrequenzwelle versehen ist.

4. Verfahren nach Anspruch 3, dadurch gekennzeichnet, daß die Referenz-Welle die durch den Höchstfrequenzverstärker (1) zu verstärkende Welle ist.

5. Verfahren nach einem der vorhergehenden Ansprüche, dadurch gekennzeichnet, daß der Höchstfrequenzverstärker (1) in einem Höchstfrequenzsender enthalten ist.

6. Vorrichtung zur Durchführung des Verfahrens nach einem der vorhergehenden Ansprüche, dadurch gekennzeichnet, daß er wenigstens folgendes enthält:

   - Verstärkungsmittel (32), die an ihrem Ausgang eine der Spannungsdifferenz an ihrem positiven Eingang und an ihrem negativen Eingang proportionale Spannung liefern, wobei ein Eingang mit einem Ausgang des Höchstfrequenzverstärkers (1) verbunden ist, der ein Abbild der Spannung zwischen den Elektroden der Röhre abgibt,
   - eine Spannungsreferenz (33), die mit dem anderen Eingang der Verstärkermittel (32) verbunden ist,
   - einen Phasenschieber (31), dessen Eingang die zu verstärkende Welle empfängt, dessen Steuereingang mit dem Ausgang der Verstärkermittel (32) verbunden ist und dessen Ausgang mit dem Eingang des Höchstfrequenzverstärkers (1) verbunden ist.

7. Vorrichtung nach Anspruch 6, dadurch gekennzeichnet, daß die Spannungsreferenz (33) ein Abbild der Nennspannung zwischen den Elektroden der Röhre des Höchstfrequenzverstärkers (1) liefert.

8. Vorrichtung nach einem der Ansprüche 6 oder 7, dadurch gekennzeichnet, daß sie einer Regelschleife für die Phase der Ausgangswelle des Höchstfrequenzverstärkers zugeordnet ist und folgendes enthält:

   - einen ersten Koppler (2), der das zu verstärkende Signal empfängt und dessen Ausgang mit dem Eingang eines Mischers (4) verbunden ist,
   - einen zweiten Koppler (5), dessen Eingang mit dem Ausgang des Höchstfrequenzverstärkers (1) verbunden ist und der einen mit dem anderen Eingang des Mischers (4) verbundenen Ausgang aufweist,
   - einen analogen Verstärker (6), dessen Eingang mit dem Ausgang des Mischers (4) verbunden ist,
   - einen zweiten Phasenschieber (3), dessen Eingang mit dem Ausgang des ersten Kopplers (2) verbunden ist, dessen Steuereingang mit dem Ausgang des analogen Verstärkers (6) verbunden ist und dessen Ausgang mit dem Eingang des Phasenschiebers (31) verbunden ist.

**Claims**

1. Method for compensating for a voltage variation between the electrodes of the tube of a UHF amplifier (1), the voltage variation causing a phase shift of the output wave from the UHF amplifier (1), characterized in that it consists in creating a phase shift of the wave entering the tube of the UHF amplifier (1) substantially proportional to the voltage variation and in the direction opposite that of the phase shift of the output wave created by this voltage variation.

2. Method according to Claim 1, characterized in that the ratio of the phase shift of the wave entering the tube to the voltage variation is substantially equal to the ratio of the phase shift of the output wave created by the voltage variation to this same voltage variation, in absolute values.

3. Method according to either of Claims 1 and 2, characterized in that the UHF amplifier (1) further has a loop (2, 3, 4, 5, 6) locking the phase of its output wave to the phase of a reference UHF wave.

4. Method according to Claim 3, characterized in that the reference wave is the wave to be amplified by the UHF amplifier (1).

5. Method according to any one of the preceding claims, characterized in that the UHF amplifier (1) is contained in a UHF transmitter.

6. Device for implementing the method according to any one of the preceding claims, characterized in that it includes at least:

- means of amplification (32) delivering on their output a voltage proportional to the voltage difference present between their positive input and their negative input, one input being connected to an output of the UHF amplifier (1) giving an image of the voltage between the electrodes of the tube;
- a voltage reference (33) connected to the other input of the means of amplification (32);
- a phase shifter (31), the input of which receives the wave to be amplified, its control input being connected to the output of the means of amplification (32) and its output being connected to the input of the UHF amplifier (1).

7. Device according to Claim 6, characterized in that the voltage reference (33) delivers an image of the nominal voltage between the electrodes of the tube of the UHF amplifier (1).

8. Device according to either of Claims 6 and 7, characterized in that it is associated with a loop locking the phase of the output wave from the UHF amplifier, including:

- a first coupler (2) receiving the signal to be amplified, one output of which is connected to the input of a mixer (4);
- a second coupler (5), the input of which is connected to the output of the UHF amplifier (1) and an output of which is connected to the other input of the mixer (4);
- an analogue amplifier (6), the input of which is connected to the output of the mixer (4);
- a second phase shifter (3), the input of which is connected to the output of the first coupler (2), its control input being connected to the output of the analogue amplifier (6), and its output being connected to the input of the phase shifter (31).

FIG.1

FIG.2a

FIG.2b

FIG.3